# EUROPEAN PATENT APPLICATION

(11) **EP 4 503 092 A1**
(43) Date of publication of application: **05.02.2025**
(21) Application number: 24184203.8
(22) Date of filing: 25.06.2024
(51) Int. Cl.: H01L 21/04, H01L 23/552, H01L 29/16, H01L 29/66

(54) **METHODS FOR IMPROVING PASSIVATION LAYER DURABILITY**

(30) Priority: 01.08.2023 US 202318363149
(71) Applicant: STMicroelectronics International N.V., 1228 Plan-les-Ouates, Geneva (CH)
(72) Inventor: BELLOCCHI, Gabriele, 95124 CATANIA (IT); RASCUNÀ, Simone, 95129 CATANIA (IT); TORRISI, Giacomo, 95129 CATANIA (IT)
(74) Representative: Studio Torta S.p.A.

(57) **Abstract**

Methods, systems, and devices for improving passivation layer durability are described. A device may include a semiconductor substrate elongated along a first direction and a second direction. The first direction may be parallel to a width of the semiconductor substrate and the second direction may be parallel to a depth of the semiconductor substrate. The device may include one or more layers formed above the semiconductor substrate with respect to a third direction parallel to a height of the semiconductor substrate. At least a region of the one or more layers may include circuitry. The device may include a passivation layer formed above the one or more layers with respect to the third direction. The passivation layer may include a plurality of cavities that each extend through the passivation layer. The plurality of cavities and the circuitry may be nonoverlapping with respect to the first direction and the second direction.

## Description

### FIELD OF THE INVENTION

Example embodiments of the present disclosure generally relate to semiconductor devices and fabrication techniques. More specifically, the present disclosure relates to methods for improving passivation layer durability.

### BACKGROUND

Some semiconductor devices may include layers of various materials, formed in a stack above a semiconductor substrate. Such semiconductor devices may be formed using a variety of techniques, such as photolithography, etching, deposition, doping, and other techniques. Such techniques may be utilized to form the various materials into patterns and configurations that enable the operation of the semiconductor device. In some cases, a semiconductor device may include various structures for coupling with other devices, such as other semiconductor devices. For example, a semiconductor device may include one or more layers formed in such a way that the semiconductor device may be coupled with another semiconductor device (e.g., via soldering, via flip-chip bonding). In some cases, a semiconductor device may include dissimilar materials with geometric discontinuities including interfaces, corners, and edges. Such semiconductor devices may be subjected to non-uniform thermal cycling during manufacturing, testing, storage, and operation. Due to differences in thermochemical properties of each material and geometric discontinuities, interfaces between materials may be prone to various types of failures, such as delamination.

### BRIEF SUMMARY

The present invention relates to an apparatus and to a method, as defined in the annexed claims.

Various embodiments described herein relate to methods, apparatuses, and systems for improving passivation layer durability. In one aspect, an apparatus includes a semiconductor substrate elongated along a first direction and a second direction, the first direction parallel to a width of the semiconductor substrate and the second direction parallel to a depth of the semiconductor substrate, one or more layers formed above the semiconductor substrate with respect to a third direction parallel to a height of the semiconductor substrate, where at least a region of the one or more layers includes circuitry, and a passivation layer formed above the one or more layers with respect to the third direction, the passivation layer including a plurality of cavities that each extend through the passivation layer, where the plurality of cavities and the circuitry are non-overlapping along the third direction (that is, they are staggered from one another when considered on the plane defined by the first direction and the second direction).

In some embodiments, the one or more layers may include an insulating layer formed between the circuitry and the passivation layer, where each cavity of the plurality of cavities exposes a surface of the insulating layer. In some embodiments, each cavity of the plurality of cavities is formed in a shape of an elliptical cylinder including a height axis parallel to the third direction. In some embodiments, a ratio between a major axis and a minor axis of each elliptical cylinder is 3 to 1. In some embodiments, the plurality of cavities are arranged in a rectangular pattern that includes uniform spacing between each cavity of the plurality of cavities. In some cases, all four sides of the rectangular pattern may have equal lengths (e.g., the rectangular pattern is a square). In some other cases, sides of the rectangular patterns may have different lengths (e.g., the rectangular pattern is a rectangle).

In some embodiments, the semiconductor substrate includes a silicon carbide material. In some embodiments, the one or more layers include a silicon carbide layer formed in contact with the semiconductor substrate, a metal layer formed at least partially in contact with the silicon carbide layer, and a silicon nitride layer formed at least partially in contact with the metal layer. In some embodiments, the circuitry may include transistor circuitry. Other technical features are readily apparent to one skilled in the art from the following figures, descriptions, and claims.

In one aspect, a method may include forming a semiconductor substrate elongated along a first direction and a second direction, the first direction parallel to a width of the semiconductor substrate and the second direction parallel to a depth of the semiconductor substrate, forming one or more layers above the semiconductor substrate with respect to a third direction parallel to a height of the semiconductor substrate, where at least a region of the one or more layers includes circuitry, and forming a passivation layer above the one or more layers with respect to the third direction, the passivation layer includes a plurality of cavities that each extend through the passivation layer, where the plurality of cavities and the circuitry are non-overlapping along the third direction (that is, they are staggered from one another when considered on the plane defined by the first direction and the second direction).

The method may also include forming the one or more layers including an insulating layer between the circuitry and the passivation layer, where each cavity of the plurality of cavities exposes a surface of the insulating layer. In some embodiments, forming each cavity of the plurality of cavities may include forming a cavity in a shape of an elliptical cylinder including a height axis parallel to the third direction. In some embodiments, a ratio between a major axis and a minor axis of each elliptical cylinder is 3 to 1. In some embodiments, the plurality of cavities are arranged in a rectangular pattern including uniform spacing between each cavity of the plurality of cavities. The method may also include forming the semiconductor substrate using a silicon carbide material.

In some embodiments, forming the one or more layers may include forming a silicon carbide layer in contact with the semiconductor substrate, forming a metal layer at least partially in contact with the silicon carbide layer, and forming a silicon nitride layer at least partially in contact with the metal layer. Other technical features are readily apparent to one skilled in the art from the following figures, descriptions, and claims.

In one aspect, a method for forming a product may include forming a semiconductor substrate elongated along a first direction and a second direction, the first direction parallel to a width of the semiconductor substrate and the second direction parallel to a depth of the semiconductor substrate, forming one or more layers above the semiconductor substrate with respect to a third direction parallel to a height of the semiconductor substrate, where at least a region of the one or more layers includes circuitry, and forming a passivation layer formed above the one or more layers with respect to the third direction, the passivation layer including a plurality of cavities that each extend through the passivation layer, where the plurality of cavities and the circuitry are non-overlapping along the third direction (that is, they are staggered from one another when considered on the plane defined by the first direction and the second direction).

In some embodiments, forming the one or more layers may include forming an insulating layer between the circuitry and the passivation layer, where each cavity of the plurality of cavities exposes a surface of the insulating layer. In some embodiments, forming each cavity of the plurality of cavities may include forming a cavity in a shape of an elliptical cylinder including a height axis parallel to the third direction. In some embodiments, a ratio between a major axis and a minor axis of each elliptical cylinder is 3 to 1. In some embodiments, the plurality of cavities are arranged in a rectangular pattern including uniform spacing between each cavity of the plurality of cavities. Other technical features are readily apparent to one skilled in the art from the following figures, descriptions, and claims.

In some embodiments, a non-transitory computer-readable storage medium may include instructions that when executed by a computer, cause the computer to form a semiconductor substrate elongated along a first direction and a second direction, the first direction parallel to a width of the semiconductor substrate and the second direction parallel to a depth of the semiconductor substrate, form one or more layers above the semiconductor substrate with respect to a third direction parallel to a height of the semiconductor substrate, where at least a region of the one or more layers includes circuitry, and form a passivation layer formed above the one or more layers with respect to the third direction, the passivation layer including a plurality of cavities that each extend through the passivation layer, where the plurality of cavities and the circuitry are non-overlapping along the third direction (that is, they are staggered from one another when considered on the plane defined by the first direction and the second direction).

In some cases, forming the one or more layers may include form an insulating layer between the circuitry and the passivation layer, where each cavity of the plurality of cavities exposes a surface of the insulating layer. In some cases, forming each cavity of the plurality of cavities includes forming a cavity in a shape of an elliptical cylinder including a height axis parallel to the third direction. In some cases, the plurality of cavities are arranged in a rectangular pattern that includes uniform space between each cavity of the plurality of cavities. In some cases, forming the semiconductor substrate includes form the semiconductor substrate using a silicon carbide material.

In some cases, forming the one or more layers includes forming a silicon carbide layer in contact with the semiconductor substrate, forming a metal layer at least partially in contact with the silicon carbide layer, and forming a silicon nitride layer at least partially in contact with the metal layer. In some cases, a ratio between a major axis and a minor axis of each elliptical cylinder is 3 to 1. Other technical features are readily apparent to one skilled in the art from the following figures, descriptions, and claims.

In some embodiments, an apparatus includes a processor. The apparatus also includes a memory storing instructions that, when executed by the processor, configure the apparatus to form a semiconductor substrate elongated along a first direction and a second direction, the first direction parallel to a width of the semiconductor substrate and the second direction parallel to a depth of the semiconductor substrate, form one or more layers above the semiconductor substrate with respect to a third direction parallel to a height of the semiconductor substrate, where at least a region of the one or more layers includes circuitry, and form a passivation layer formed above the one or more layers with respect to the third direction, the passivation layer includes a plurality of cavities that each extend through the passivation layer, where the plurality of cavities and the circuitry are non-overlapping along the third direction (that is, they are staggered from one another when considered on the plane defined by the first direction and the second direction).

The apparatus may also be configured to form the one or more layers including forming an insulating layer between the circuitry and the passivation layer, where each cavity of the plurality of cavities exposes a surface of the insulating layer. The apparatus may also be configured to form each cavity of the plurality of cavities including forming a cavity in a shape of an elliptical cylinder including a height axis parallel to the third direction. The apparatus may also be configured to arrange the plurality of cavities in a rectangular pattern including uniform spacing between each cavity of the plurality of cavities. In some cases, forming the semiconductor substrate includes forming the semiconductor substrate using a silicon carbide material.

In some cases, forming the one or more layers includes form a silicon carbide layer in contact with the semiconductor substrate, forming a metal layer at least partially in contact with the silicon carbide layer, and forming a silicon nitride layer at least partially in contact with the metal layer. Other technical features are readily apparent to one skilled in the art from the following figures, descriptions, and claims. In some cases, a ratio between a major axis and a minor axis of each elliptical cylinder is 3 to 1. Other technical features are readily apparent to one skilled in the art from the following figures, descriptions, and claims.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example of a material arrangement that supports methods for improving passivation layer durability;
FIG. 2 illustrates an example of a material arrangement that supports methods for improving passivation layer durability;
FIG. 3 illustrates an example of a material arrangement that supports methods for improving passivation layer durability;
FIG. 4 illustrates an example of a flowchart that supports methods for improving passivation layer durability; and
FIG. 5 illustrates an example of a flowchart that supports methods for improving passivation layer durability.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

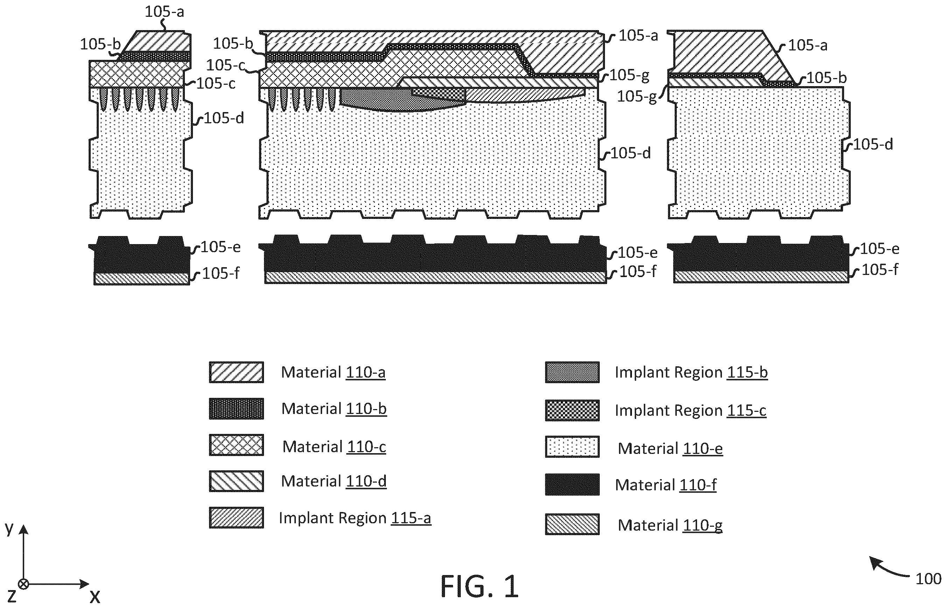

FIG. 1 illustrates an example of a material arrangement 100 that supports methods for improving passivation layer durability. In some cases, the material arrangement 100 may illustrate one or more portions of semiconductor device or any other electronic device. For example, the material arrangement 100 may illustrate multiple portions of a silicon carbide power device, such as a diode or a transistor. The material arrangement 100 is an example of a device or one or more portions of a device employed in a variety of applications such as power electronics applications. The material arrangement 100 illustrates one or more section views of a semiconductor device where some portions of the semiconductor device may be truncated or not shown. For example, the material arrangement 100 illustrates six portions of a semiconductor device, which are shown separately to illustrate that intervening materials 110 or layers 105 are included between the portions. However, in some cases, the six portions may not include intervening materials 110 or layers 105 and may instead be formed in contact with one another. As described herein, each layer 105 of the material arrangement 100 may correspond to a respective material 110. Additionally, the layer 105-d may include implant regions 115, which are portions of the layer 105-d that are implanted or doped according to a specific implantation method or doping method. Although some examples of specific materials 110 or material compounds are described herein, the material arrangement 100 may include any combination of materials 110.

The material arrangement 100 include a layer 105-a. The layer 105-a is an example of a passivation layer, which insulates or otherwise protect one or more layers 105 of the material arrangement 100 (e.g., layers 105 located below the layer 105-a with respect to the y-direction). In some cases, the layer 105-a electrically insulates one or more layers of the material arrangement 100 or otherwise prevent the transmission of radio waves (e.g., electromagnetic fields) or electrical signals through the layer 105-a. The layer 105-a also serves to protect the material arrangement 100 from incurring damage due to weathering or mechanical stresses. The layer 105-a is formed using a material 110-a (e.g., a passivation material, an insulating material). In some cases, the material 110-a is one among polyimide, silicon nitride, silicon dioxide, aluminum oxide, or any other insulating material. In one non-limiting embodiment, the layer 105-a is formed in contact with the layer 105-b.

The material arrangement 100 include the layer 105-b. The layer 105-b is in particular an insulating layer (e.g., a second insulating layer), which is included in the material arrangement 100 (e.g., in addition to the layer 105-a) for improving adhesion of the layer 105-a. For example, the layer 105-a may more readily adhere to the layer 105-b than the layer 105-c. The layer 105-b insulates or otherwise protects one or more layers 105 of the material arrangement 100 (e.g., one or more layers 105 located below the layer 105-b with respect to the y-direction). In some cases, the layer 105-b electrically insulates one or more layers 105 of the material arrangement 100 or otherwise prevent the transmission of radio waves (e.g., electromagnetic fields) or electrical signals through the layer 105-b. The layer 105-b is for example formed using a material 110-b, being or including an insulating material such as polyimide, silicon nitride, silicon dioxide, aluminum oxide, or any other insulating material. In one illustrative example, the material 110-a is polyimide and the material 110-b is silicon nitride. In some other examples, however, the layer 105-a and the layer 105-b are formed using a same material (e.g., polyimide). As described herein, the layer 105-b is formed in contact with the layer 105-c, the layer 105-a, the layer 105-g, and the layer 105-d.

The material arrangement 100 includes the layer 105-c. The layer 105-c is in particular a metallic layer, which may be utilized for routing electrical signals. The layer 105-c is an example of a redistribution layer or any other type of conductive layer or conductive trace. The layer 105-c is in particular formed using the material 110-c. The material 110-c is for example one of copper, tungsten, aluminum, titanium, silver, or any other conductive material. As described herein, the layer 105-c is formed in contact with any combination of the layer 105-b, the layer 105-d, and the layer 105-g.

The material arrangement 100 includes the layer 105-d. The layer 105-d is in particular a semiconductor layer, which may be utilized for forming circuitry. The layer 105-d includes for example implant regions 115 (e.g., implant region 115-a, implant region 115-b, implant region 115-c). The implant regions 115 are examples of doped regions of the layer 105-d and a depletion region of the layer 105-d. For example, the implant region 115-a is a ring implant region, which is a region of the layer 105-d that is doped according to a specific process (e.g., n-type doping). The implant region 115-b is an example of an anode implant region, which is doped differently than the implant region 115-a (e.g., using p-type doping). The implant region 115-b is an example of an anode or positive terminal for the material arrangement 100 (e.g., for a diode). The layer 105-d may also include the implant region 115-c, which is an example of a depletion zone. The layer 105-d may be formed using the material 110-e (e.g., a semiconductor material). The material 110-e is in particular of one among: silicon, silicon carbide, gallium arsenide, gallium nitride, indium phosphide, germanium, or any other semiconductor material. As described herein the layer 105-d is formed in contact with the layer 105-e, the layer 105-c, the layer 105-g, and the layer 105-b.

The material arrangement 100 includes the layer 105-g. The layer 105-g may be an example of an oxide layer, which may provide electrical insulation. In some cases, the layer 105-g may be an example of an interlayer dielectric (ILD) or a gate dielectric. The layer 105-g may be formed using the material 110-d. The material 110-d is an example of an oxide material, such as silicon dioxide, aluminum oxide, or any other dielectric material. As described herein, the layer 105-g is formed in contact with the layer 105-b, the layer 105-c, and the layer 105-d.

The material arrangement 100 includes the layer 105-e. The layer 105-e is an example of a semiconductor substrate. In some cases, the layer 105-c is formed using the material 110-f. The material 110-f is an example of any semiconductor material, such as silicon, silicon carbide, gallium arsenide, gallium nitride, indium phosphide, germanium. In some cases, the material 110-f and the material 110-e may be different. In some other cases, however, the material 110-f and the material 110-e may be a same material, such as silicon carbide. As described herein, the layer 105-e is formed in contact with the layer 105-d and the layer 105-f.

The material arrangement 100 includes the layer 105-f. The layer 105-f is an example of a solder alloy layer. Although the layer 105-f is shown in FIG. 1 as a single material (e.g., the material 110-g), the layer 105-f may be formed using a combination of materials 110. For example, the material 110-g is an example of an alloy that includes titanium, nickel, vanadium, and silver. The layer 105-f may be used for interconnecting or coupling (e.g., via soldering) the material arrangement 100 with semiconductor packaging. As described herein, the layer 105-f is formed in contact with the layer 105-e.

In some cases, the material arrangement 100 is formed using one or more operations, such as lithography, etching, deposition, doping, metallization, soldering, or any other type of operation. In some cases, the layer 105-e is deposited on the layer 105-f, the layer 105-d is deposited on the layer 105-e, the layer 105-g is deposited on the layer 105-d, and so forth. In some cases, the material arrangement 100 includes one or more layers 105 for coupling the layer 105-d, regions of the layer 105-d, or the layer 105-e (e.g., a redistribution layer) with circuitry of one or more other devices, such as another semiconductor device (not shown).

As described herein, the material arrangement 100 may include a variety of dissimilar materials with geometric discontinuities including interfaces, corners, and edges. The material arrangement 100 may be subjected to non-uniform thermal cycling during manufacturing, testing, storage, and operation. Due to differences in thermochemical properties of each material 110 and geometric discontinuities, interfaces between materials 110 (e.g., layers 105) may be prone to failure. In some cases, the layer 105-a (e.g., the passivation layer) that electrically insulates the stack of materials may be particularly prone to mechanical failure (e.g., delamination). Additional layers 105, such as the layer 105-b (e.g., silicon nitride), is formed in contact with the layer 105-a to improve adhesion (e.g., between the layer 105-a and the layer 105-b). However, if a crack forms in the layer 105-b and delamination of the layer 105-a extends to the layer 105-c (e.g., the metal layer), electrical discharge may occur, as shown below.

The present disclosure provides techniques for improving the durability of layer 105-a by forming stress-relieving cavities through the layer 105-a. The cavities are in particular arranged along the periphery of the material arrangement 100. For example, the cavities are located such that they do not overlap with the layer 105-c, the implant region 115-a, the implant region 115-b, or the implant region 115-c (e.g., in an x-z plane). For example, locations of cavities are selected such that locations of the cavities in an x-z plane do note overlap, along the y-direction, with regions of the material arrangement 100 that include active circuitry. In other words, the cavities and the regions including circuitry are staggered from one another when considered on the x-z plane.

As described herein, locating cavities in regions that do not overlap with active circuitry of the material arrangement 100 ensures that the active circuitry is effectively insulated by the layer 105-c (e.g., such that electromagnetic fields do not escape through the cavities). Additionally, each cavity may be formed in the shape of an ellipse (e.g., an elliptical cylinder) and extends downward through the passivation layer (e.g., in the negative y-direction). Although examples described herein generally refer to cavities formed in the shape of ellipses, any cavity shape or geometry may be used. Similarly, relative distances between cavities, or the relative positioning of cavities may be modified based on one or more characteristics of the material arrangement 100.

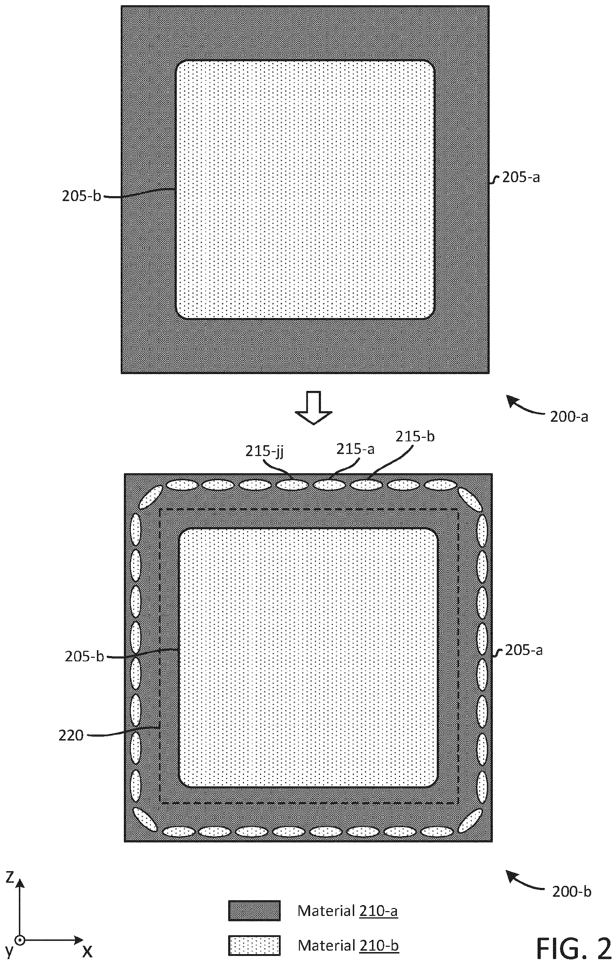

FIG. 2 illustrates examples of material arrangements 200 that support methods for improving passivation layer durability. For example, the material arrangement 200-a illustrates a layer 205-a (e.g., a passivation layer) without cavities 215, and the material arrangement 200-b illustrates a layer 205-a with cavities 215, which improves durability of the layer 205-a. The material arrangement 200-a and the material arrangement 200-b are examples of the material arrangement 100, as described with reference to FIG. 1, or portions of the material arrangement 100. The material arrangement 200-b illustrates a portion of the material arrangement 100 after one or more operations have been performed (e.g., to form cavities 215).

The material arrangement 200-a includes one or more layers 205. For example, the material arrangement 200-a includes a layer 205-a (e.g., a passivation layer) and a layer 205-b. The layer 205-b is an example of a layer 205 located below the layer 205-a with respect to the y-direction. The layer 205-b is formed using the material 210-b. The material 210-b is in particular an insulating material, such as silicon nitride, silicon dioxide, aluminum oxide, or any other insulating material. In some other cases, the material 210-b is a conductive material, such as aluminum. The layer 205-a is formed using the material 210-a, which is an example of an insulating material (e.g., different from the material 210-b). For example, the material 210-a is an example of polyimide.

The layer 205-a is formed around a periphery of a semiconductor device (e.g., a periphery of a material arrangement 200). In some cases, the layer 205-a is formed by initially depositing the material 210-a (e.g., uniformly) on the layer 205-b. A center portion of the layer 205-a may then be removed, forming a void that exposes a top surface (e.g., with respect to the y-direction) of the layer 205-b (as shown in FIG. 2). In some cases, the void formed through the layer 205-a is an example of a bolt pad opening. The bolt pad opening may enable the material arrangement 200-a to be secured to another device via one or more bolts or fasteners that connect to the layer 205-b.

As shown, the layer 205-a of the material arrangement 200-a may not include cavities 215 (e.g., peripheral cavities). Accordingly, non-uniform thermal cycling during manufacturing, testing, storage, and operation results in mechanical stresses in the layer 205-a or between the layer 205-a and the layer 205-b. For example, increasing temperature may cause the layer 205-a and the layer 205-b to expand. However, the material 210-a may have a different coefficient of thermal expansion than the material 210-b, which may cause stress between the layer 205-a and the layer 205-b. Such stresses may increase the likelihood of delamination between the layer 205-a and the layer 205-b, which may lead to failure of the material arrangement 200-a.

In accordance with one or more aspects of the present disclosure, and as shown by the material arrangement 200-b, one or more cavities 215 are formed in the layer 205-a, which may relieve stress (e.g., mechanical stress) in the layer 205-a or stress between the layer 205-a and the layer 205-b. As shown, the material arrangement 200-b includes a plurality of cavities 215 (e.g., the cavity 215-a through the cavity 215-jj). Each cavity 215 exposes a surface of the layer 205-b. Additionally, or alternatively, each cavity 215 is formed in a location that avoids overlap with circuitry (e.g., active circuitry). For example, circuitry is located within the region 220 (e.g., below the layer 205-b). Accordingly, cavities 215 are formed outside of the region 220 (e.g., along the periphery of the material arrangement 200-b). In other words, the circuitry and the cavities 215 are staggered to one another on the x-z plane.

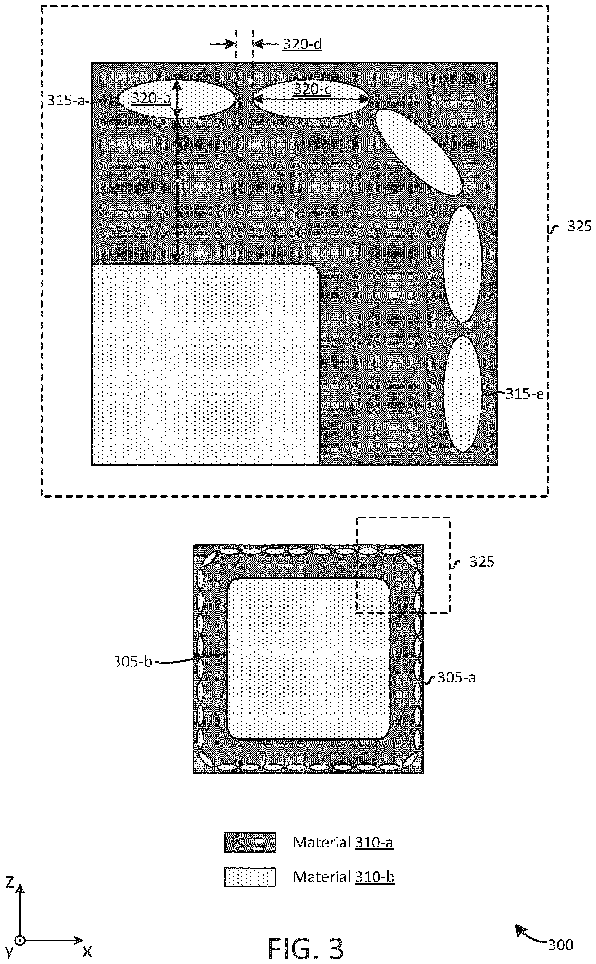

FIG. 3 illustrates an example of a material arrangement 300 that supports methods for improving passivation layer durability. The material arrangement 300 illustrates a portion of the material arrangement 200-b, as described with reference to FIG. 2. For example, a region 325 of the material arrangement 300 is an example of an expanded view of a portion of the material arrangement 200-b. The material arrangement 300 may include a layer 305-a (e.g., a passivation layer) and a layer 305-b, which are examples of the layer 205-a and the layer 205-b, respectively, as described with reference to FIG. 2. Accordingly, the layer 305-a may be formed using the material 310-a and the layer 305-b may be formed using the material 310-b. The material 310-a and the material 310-b are examples of the material 210-a and the material 210-b, respectively, as described with reference to FIG. 2. Additionally, the material arrangement 300 includes a plurality of cavities 315, which are examples of cavities 215, as described with reference to FIG. 2.

In accordance with one or more aspects of the present disclosure, each cavity 315 is formed in the shape of an elliptical cylinder. For example, each cavity 315 may have a dimension 320-b (e.g., a minor diameter, a minor axis) and a dimension 320-c (e.g., a major diameter, a major axis). For one or more cavities 315 (e.g., the cavity 315-a, the cavity 315-b), the dimension 320-b is parallel to the z-direction and the dimension 320-c is parallel to the x-direction. However, the orientation of dimensions 320 for each cavity 315 corresponds to the orientation of each cavity 315. For example, the cavity 315-e may be oriented differently than the cavity 315-a. Accordingly, the dimension 320-b for the cavity 315-e are parallel to the x-direction and the dimension 320-c for the cavity 315-e are parallel to the z-direction.

Additionally, each cavity 315 may have a height dimension (not shown). The height dimension of each cavity 315 is parallel to the y-direction. As described herein, each cavity 315 extends through (e.g., fully) the layer 305-a. Additionally, or alternatively, cavities 315 are spaced or located according to a dimension 320-a and a dimension 320-d. For example, the dimension 320-a is an example of a distance between a respective cavity 315 (e.g., the cavity 315-a) and an extent of the layer 305-a. The dimension 320-a may be selected based on a location of circuitry. For example, the dimension 320-a is selected such that each cavity 315 is located sufficiently far away from circuitry. Although not shown, the dimension 320-a is the same for each cavity 315. That is, each cavity 315 is located a same distance away from an extent of the layer 305-a. The dimension 320-d may represent a distance or spacing between respective cavities 315. In some cases, the dimension 320-d is uniform for the plurality of cavities 315. That is, spacing between each cavity 315 may be the same.

The dimensions 320 may be determined based on a mathematical relationship, an algorithm, modeling, or test results. For example, a modeling operation is performed to determine stresses present in the layer 305-a. The modeling operation outputs various stress values for given dimensions 320. Accordingly, the modeling operation selects dimensions 320 such that one or more stresses in the layer 305 are minimized. In some cases, a specific ratio of the dimension 320-c to the dimension 320-b is utilized. For example, the dimension 320-c are approximately three times greater than the dimension 320-b. Such a ratio of the dimension 320-c to the dimension 320-b is selected based on one or more stress values output by the modeling operation. For example, selecting the dimension 320-c to be approximately three times larger than the dimension 320-b substantially reduces or eliminates stresses in the layer 305-a.

Although some examples described herein refer to cavities 315, some other examples includes forming (e.g., depositing) various materials 310 in cavities 315. For example, each cavity 315 is filled (e.g., partially or fully) with a material 310 different from the material 310-a. For example, the material 310 is configured for stress relief applications or may more generally have one or more properties that enable stress reduction in the layer 305-a. The material 310 has a hardness or stiffness that is less than a hardness or stiffness of the material 310-a, which may enable the material 310 to release or eliminate stresses. For example, the material 310 is relatively flexible when compared to the material 310-a. In some cases, one or more dimensions 320 are selected or otherwise varied based on one or more dimensions of the material arrangement 300. For example, the dimensions 320 are selected to scale with a size of the material arrangement 300. In some cases, one or more of the dimensions 320 are selected or otherwise varied based on materials 310 selected for the material arrangement 300. For example, one or more of the dimensions 320 are selected based on one or more properties of the material 310-a, the material 310-b, or both.

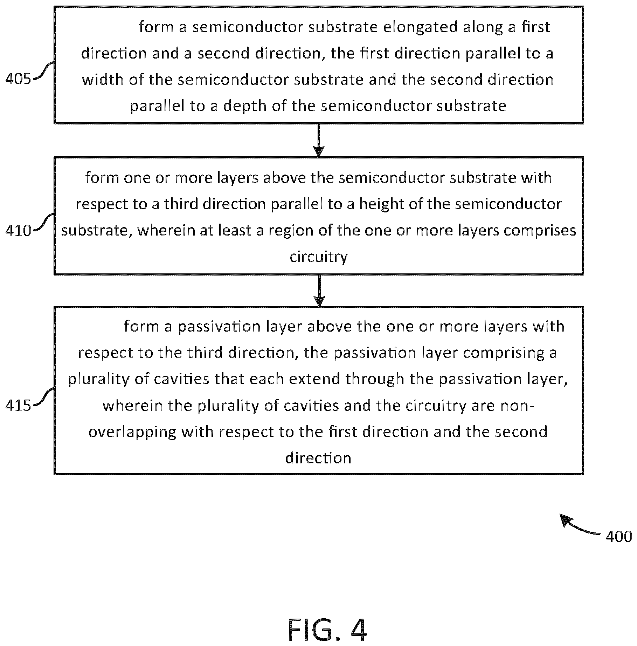

FIG. 4 illustrates an example of a flowchart illustrating a method 400 that supports improving passivation layer durability. The operations of the method 400 may be implemented by a manufacturing system or a machine configured for performing one or more operations as described herein. For example, a machine or manufacturing system configured to perform one or more deposition operations, etching operations, or any other material formation or material removal operations may perform the operations of the method 400. In some cases, a manufacturing system or machine may execute instructions to control one or more functional elements to perform the described operations. Additionally, or alternatively, a machine or manufacturing system may perform aspects of the described operations using special-purpose hardware.

At 405, the method 400 includes forming a semiconductor substrate elongated along a first direction and a second direction, the first direction parallel to a width of the semiconductor substrate and the second direction parallel to a depth of the semiconductor substrate. The operations are performed in accordance with examples as described herein. In some examples, aspects of the operations are performed using a special-purpose machine or manufacturing system.

At 410, the method 400 includes forming one or more layers above the semiconductor substrate with respect to a third direction parallel to a height of the semiconductor substrate. In some cases, at least a region of the one or more layers include circuitry (e.g., active circuitry). The operations are performed in accordance with examples as described herein. In some examples, aspects of the operations are performed using a special-purpose machine or manufacturing system.

At 415, the method 400 includes forming a passivation layer above the one or more layers with respect to the third direction. The passivation layer includes a plurality of cavities that each extend through the passivation layer. The plurality of cavities and the circuitry are non-overlapping along the third direction y (that is, they are staggered from one another when considered on the plane xz defined by the first direction x and the second direction z).. The operations are performed in accordance with examples as described herein. In some examples, aspects of the operations are performed using a special-purpose machine or manufacturing system.

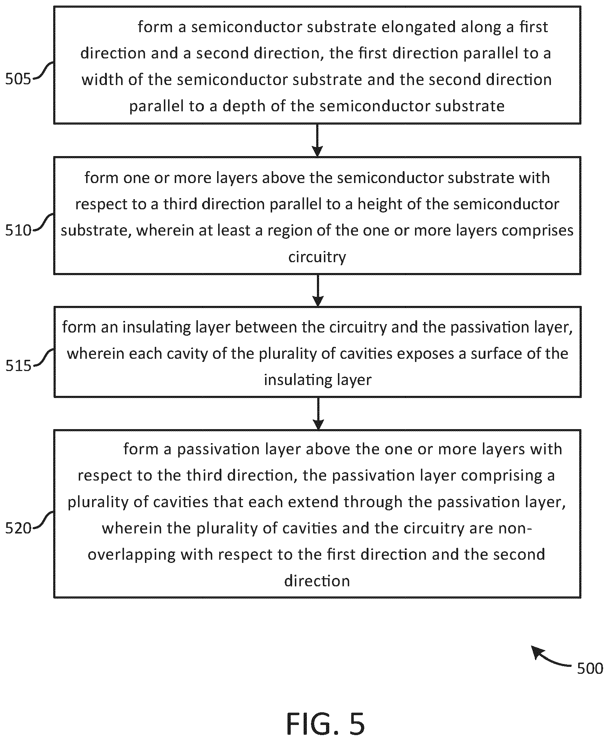

FIG. 5 illustrates an example of a flowchart illustrating a method 500 that improves passivation layer durability. The operations of the method 500 may be implemented by a manufacturing system or a machine configured for performing one or more operations as described herein. For example, a machine or manufacturing system configured to perform one or more material removal operations, or one or more material formation operations perform the operations of the method 500. In some cases, a manufacturing system or machine executes instructions to control one or more functional elements to perform the described operations. Additionally, or alternatively, a machine or manufacturing system performs aspects of the described operations using special-purpose hardware.

At 505, the method 500 includes forming a semiconductor substrate elongated along a first direction and a second direction, the first direction parallel to a width of the semiconductor substrate and the second direction parallel to a depth of the semiconductor substrate. The operations are performed in accordance with examples as described herein. In some examples, aspects of the operations are performed using a special-purpose machine or manufacturing system.

At 510, the method 500 may include forming one or more layers above the semiconductor substrate with respect to a third direction parallel to a height of the semiconductor substrate. In some cases, at least a region of the one or more layers include circuitry (e.g., active circuitry). The operations may be performed in accordance with examples as described herein. In some examples, aspects of the operations may be performed using a special-purpose machine or manufacturing system.

At 515, the method 500 includes forming an insulating layer between the circuitry and the passivation layer. Each cavity of the plurality of cavities exposes a surface of the insulating layer. In some cases, forming the one or more layers includes forming the insulating layer between the circuitry and the passivation layer. The operations are performed in accordance with examples as described herein. In some examples, aspects of the operations are performed using a special-purpose machine or manufacturing system.

At 520, the method 500 includes forming a passivation layer above the one or more layers with respect to the third direction. The passivation layer includes a plurality of cavities that each extend through the passivation layer. The plurality of cavities and the circuitry are non-overlapping along the third direction y (that is, they are staggered from one another when considered on the plane xz defined by the first direction x and the second direction z).. The operations are performed in accordance with examples as described herein. In some examples, aspects of the operations are performed using a special-purpose machine or manufacturing system.

## Claims

1. An apparatus (100), comprising:
a semiconductor substrate (105-d), in particular of Silicon Carbide, elongated along a first direction (x; z) and a second direction (z; x), the first direction being orthogonal to the second direction;
one or more layers (105-b, 105-c) formed above the semiconductor substrate with respect to a third direction (y) orthogonal to the first and the second directions, wherein at least a region (220) of the one or more layers comprises circuitry; and
a passivation layer (105-a; 205-a) formed above the one or more layers with respect to the third direction (y), the passivation layer comprising a plurality of cavities that each extend through the passivation layer, wherein the plurality of cavities (215; 315) and the region (220) comprising the circuitry are non-overlapping.

2. The apparatus of claim 1, wherein the plurality of cavities (215; 315) are located outside the region (220) comprising the circuitry, such that the plurality of cavities (215; 315) and the region (220) comprising the circuitry are non-overlapping in the third direction (y).

3. The apparatus of claim 1 or 2, wherein the one or more layers comprise:
an insulating layer formed between the region (220) comprising the circuitry and the passivation layer (105-a; 205-a), wherein each cavity of the plurality of cavities exposes a surface of the insulating layer.

4. The apparatus of anyone of the preceding claims, wherein each cavity of the plurality of cavities (215; 315) is formed in a shape of an elliptical cylinder comprising a height axis parallel to the third direction.

5. The apparatus of claim 4, wherein a ratio between a major axis and a minor axis of each elliptical cylinder is 3 to 1.

6. The apparatus of anyone of the preceding claims, wherein the plurality of cavities (215; 315) are arranged in a rectangular pattern comprising uniform spacing between each cavity of the plurality of cavities.

7. The apparatus of anyone of the preceding claims, wherein the one or more layers comprise:
a silicon carbide layer formed in contact with the semiconductor substrate;
a metal layer formed at least partially in contact with the silicon carbide layer; and
a silicon nitride layer formed at least partially in contact with the metal layer.

8. The apparatus of anyone of the preceding claims, wherein the first direction (x; z) is parallel to a width of the semiconductor substrate, the second direction (z; x) is parallel to a depth of the semiconductor substrate, and the third direction (y) is parallel to a height of the semiconductor substrate.

9. A method, comprising:
forming a semiconductor substrate (105-d) elongated along a first direction (x; z) and a second direction (z; x), the first direction being orthogonal to the second direction;
forming one or more layers (105-b, 105-c) above the semiconductor substrate with respect to a third direction (y) orthogonal to the first and second directions, wherein at least a region (220) of the one or more layers comprises circuitry; and
forming a passivation layer (105-a; 205-a) above the one or more layers with respect to the third direction, the passivation layer comprising a plurality of cavities (215; 315), each cavity extending through the passivation layer, wherein the plurality of cavities and the region (220) comprising the circuitry are non-overlapping.

10. The method of claim 9, comprising forming the plurality of cavities (215; 315) outside the region (220) comprising the circuitry, such that the plurality of cavities (215; 315) and the region (220) comprising the circuitry are non-overlapping in the third direction (y).

11. The method of claim 9 or 10, wherein forming the one or more layers comprises:
forming an insulating layer between the circuitry and the passivation layer, wherein each cavity of the plurality of cavities exposes a surface of the insulating layer.

12. The method of anyone of claims 9-11, wherein forming each cavity of the plurality of cavities comprises:
forming a cavity in a shape of an elliptical cylinder comprising a height axis parallel to the third direction.

13. The method of claim 12, wherein a ratio between a major axis and a minor axis of each elliptical cylinder is 3 to 1.

14. The method of anyone of claims 9-13, wherein the plurality of cavities (215; 315) are arranged in a rectangular pattern comprising uniform spacing between each cavity of the plurality of cavities.

15. The method of anyone of claims 9-14, wherein forming the one or more layers comprises:
forming a silicon carbide layer in contact with the semiconductor substrate;
forming a metal layer at least partially in contact with the silicon carbide layer; and
forming a silicon nitride layer at least partially in contact with the metal layer.
